# EUROPÄISCHE PATENTSCHRIFT

(11) **EP 2 532 036 B1**
(45) Veröffentlichungstag und Bekanntmachung des Hinweises auf die Patenterteilung: **14.12.2016**
(21) Anmeldenummer: 10795370.5
(22) Anmeldetag: 20.12.2010
(51) Int. Cl.: H01L 35/30

(54) **WÄRMETAUSCHER FÜR THERMOELEKTRISCHE GENERATOREN**
HEAT EXCHANGER FOR THERMOELECTRIC GENERATORS
ÉCHANGEUR DE CHALEUR POUR GÉNÉRATEURS THERMOÉLECTRIQUES

(30) Priorität: 01.02.2010 DE 102010001417
(43) Veröffentlichungstag der Anmeldung: 12.12.2012
(73) Patentinhaber: Robert Bosch GmbH, 70442 Stuttgart (DE)
(72) Erfinder: GLASER, Patrick, 70197 Stuttgart (DE)
(86) Internationale Anmeldenummer: PCT/EP2010/070181
(87) Internationale Veröffentlichungsnummer: WO 2011/091911

(56) Entgegenhaltungen:
- EP-A2- 1 906 463
- US-A1- 2005 274 501
- US-A1- 2006 157 102

## Beschreibung

### Stand der Technik

Die von Kraftfahrzeugen produzierte Abgaswärme, die je nach Modell bis zu 35% betragen kann, wird häufig ungenutzt an die Umwelt abgegeben. Eine effektive Nutzung dieser Wärmeenergie würde jedoch eine Verringerung des Kraftstoffbedarfs mit sich bringen.

Eine Möglichkeit der Nutzung dieser Abgaswärme sind thermoelektrische Generatoren (TEG). In den freien Enden zweier miteinander verbundener Leiter wird bei einer Temperaturdifferenz entlang der Leiter eine elektrische Spannung erzeugt. Vorrichtungen zur Erzeugung von Energie aus der Abgaswärme sind bekannt und beispielsweise in DE 10 2008 005 334 A1 offenbart.

Zur besseren Nutzung der Abgasenergie weisen Strömungskanäle, durch die das wärmeabgebende Fluid strömt, teilweise Versteifungseinrichtungen in Form von Rippen auf, welche normalerweise in äquidistantem Abstand zueinander angebracht sind. Diese Rippen vergrößern die Oberfläche des Strömungskanals und sorgen so für eine bessere Wärmeübertragung zwischen wärmeabgebenden Fluid und dem Strömungskanal.

Derzeit existieren keine Serienanwendungen für thermoelektrische Generatoren zur Abgaswärmerückgewinnung. Versuchsträger für diese Anwendungen bestehen meist aus unberippten oder durchgehend berippten Flachkanälen.

Unberippte Kanäle weisen schlechte Wärmeübergangskoeffizienten auf und verhindern eine effiziente Nutzung der Abgasenergie.

In berippten Kanälen lassen sich hohe Wärmestromdichten realisieren, wodurch der notwendige Bauraum und die notwendige Zahl an thermoelektrischen Generatoren reduziert werden kann. Eine durchgehende Berippung führt bei typischer Abgasanwendungen jedoch zu einer kontinuierlichen Abnahme der TEG-Heißseitentemperatur in Strömungsrichtung, resultierend aus den sich in Strömungsrichtung nur schwach ändernden Wärmeübergangskoeffizienten, auf Grund derer die TEG-Heißseitentemperatur kontinuierlich der stark sinkenden Abgastemperatur folgt.

DE 10 2007 062 826 A1 offenbart einen Wärmetauscher für ein Kraftfahrzeug. Die Offenlegungsschrift zeigt einen Wärmetauscher mit Rippenelementen, die in unterschiedlicher Dichte angeordnet sind, wodurch eine Beeinflussung des Wärmeübergangs stattfindet.

Zum Zwecke der Gewichts- und Kosteneinsparung als auch der Wärmestrommaximierung haben die Rippenelemente im Bereich des Eintritts eines ersten Fluids eine besonders dichte Anordnung, um die dort abfallende größte Wärmeübertragung auf ein zweite Fluid zu unterstützen.

Die EP 1 906 463 A2 und US 2006/0157102 A1 offenbaren einen thermoelektrischen Wärmetauscher mit einer Vielzahl von Kanälen.

US 2005/0274501 A1 offenbart einen Wärmetauscher mit variabler Rippendichte.

### Offenbarung der Erfindung

Um einen möglichst großen Teil der im Abgas, insbesondere dem einer Verbrennungskraftmaschine eines Kraftfahrzeuges, enthaltenen thermischen Energie nutzbar zu machen, ist ein erfindungsgemäßer Wärmetauscher für thermoelektrische Generatoren (TEG) mit Rippen zur Vergrößerung der Oberfläche eines Strömungskanals, und damit zu einer bessere Wärmeübertragung, ausgestattet. Erfindungsgemäß sind diese Rippen nicht in äquidistantem Abstand zueinander angebracht, sondern angepasst an den zu erwartenden Wärmestrom mit in Strömungsrichtung zunehmender Rippedichte und wobei eine Zunahme der Anzahl der Rippen mit elementenweiser Zunahme der thermoelektrischen Generatoren erfolgt.

Der erfindungsgemäß vorgeschlagene Wärmetauschern mit angepasster Rippendichte für thermoelektrische Generatoren ermöglicht eine effektive Abgaswärmerückgewinnung, die es ermöglicht, aus dieser sonst ungenutzten Energie elektrischen Strom zu gewinnen, der für verschiedene Systeme des PKW genutzt werden kann und so entscheidend zum Einsparen von Kraftstoff beiträgt, den CO₂-Ausstoß reduziert und Schadstoffemissionen senkt. Damit verbessern thermoelektrische Generatoren die E-nergieeffizienz, Umweltverträglichkeit und Wirtschaftlichkeit und sind dabei robust, wartungsfrei und für verschiedene Einsatzgebiete anpassbar.

Eine durchgehende Berippung würde bei typischen Abgasanwendungen zu einer kontinuierlichen Abnahme der TEG-Heißseitentemperatur in Strömungsrichtung führen, da die Wärmeübergangskoeffizienten sich nur schwach in Strömungsrichtung ändernden und die TEG-Heißseitentemperatur kontinuierlich der stark sinkenden Abgastemperatur folgt. Dies hat zur Folge, daß die thermoelektrischen Generatoren in den letzten Reihen des Wärmetauschers auf Grund der geringen Temperaturdifferenz, die den Wirkungsgrad verringert, und auf Grund der geringen Wärmestromdichte ineffizient arbeiten. Vor allem, wenn die zulässige Maximaltemperatur, zum Beispiel durch das verwendete TEG-Material, begrenzt ist, muss die Wandtemperatur am Eintritt des Wärmetauschers auf die zulässige Maximaltemperatur begrenzt werden und verringert somit die insgesamt nutzbare Energie. Mit der erfindungsgemäß vorgeschlagenen angepassten Rippendichte, wird eine wesentlich effizienter Nutzung des Wärmestroms als bei äquidistanter Berippung erreicht.

Die Steigerung des Wärmeübergangs durch erhöhte Rippendichte ist ein bekannter physikalischer Zusammenhang, jedoch erfolgt diese Zunahme der Rippendichte in entgegengesetzter Richtung als aus dem Stand der Technik bekannt, wo die Einsparung von Material im Vordergrund steht. Eine solche gezielte Veränderung der Rippendichte führt zu einer Vergleichmäßigung des Wärmestroms und damit zu einem, über die gesamte Länge des Wärmetauschers, definierten Temperaturprofil.

Eine vorteilhafte Vergleichmäßigung der TEG-Heißseitentemperatur kann durch eine Steigerung des Wärmeübergangs in Strömungsrichtung erzielt werden. Dies kann durch eine Aufteilung der Längsrippen und eine zunehmende Rippendichte in Strömungsrichtung erzielt werden. Wenn eine maximal zulässige TEG-Temperatur die TEG-Heißseitentemperatur am Eintritt begrenzt, kann durch eine zunehmende Rippendichte insgesamt eine höhere Wärmeleistung des Wärmetauschers erzielt werden. Diese Methode kann sowohl für die in Wärmetauschern üblichen gewellten Rippen, beispielsweise Herringbone-Rippen, als auch für ebene Rippen angewandt werden. Des weiteren können ebene und gewellte Rippen kombiniert werden. Gewellte Rippen weisen bei gleichem Wärmeübergang eine geringere Rippendichte und damit ein reduziertes Gewicht, jedoch auch eine geringere Festigkeit auf. Sie bieten somit Vorteile in Bereichen des Wärmetauschers, in denen ein hoher Wärmeübergang erforderlich ist. In Bereichen mit niedrigem Wärmeübergang können unter Umständen dichter gepackte ebene Rippen bevorzugt werden, wenn eine externe Vorspannkraft auf das System aufgebracht wird.

Es können beliebig viele Teilungen eingeführt werden, wobei jedoch die Neigung zu Fouling-Ablagerungen, sprich durch Inhaltsstoffe des benutzten Heizmediums verursachten Verschmutzung, an den Vorderkanten der Rippen beachtet werden muss. Eine sinnvolle Unterteilung kann beispielsweise durch eine TEG-elementenweise Aufteilung vorgenommen werden.

Ein weiterer Vorteil ist ein erhöhter Gesamtwärmestrom. Je größer die Temperaturunterschiede zwischen den Leitern ist, desto mehr Strom können die thermoelektrischen Generatoren produzieren. Die thermoelektrischen Generatoren in den letzten Reihen des Wärmetauschers arbeiten auf Grund der geringen Temperaturdifferenz und auf Grund der geringen Wärmestromdichte ineffizient. Vor allem, wenn die zulässige Maximaltemperatur begrenzt ist (zum Beispiel durch das verwendete TEG-Material), muss die Wandtemperatur am Eintritt des Wärmetauschers auf die zulässige Maximaltemperatur begrenzt werden und verringert somit die insgesamt nutzbare Energie. Durch eine angepasste Rippendichte wird eine Vergleichmäßigung der Temperaturdifferenz und der Wärmestromdichte erreicht, was zu einer effizienteren Nutzung der thermoelektrischen Generatoren beiträgt.

Eine Anpassung der Rippendichte an den Wärmestrom ist speziell für die Anwendung in thermoelektrischen Generatoren sinnvoll, da dadurch die thermoelektrischen Module in Längsrichtung des Abgases, trotz Abnahme der Abgastemperatur, ähnliche Abgasleistung wahrnehmen. Dadurch wird in den unterschiedlichen thermoelektrischen Modulreihen aktive elektrische Leistung erzeugt, was die Anforderungen an den Gleichstromsteller reduziert.

### Kurze Beschreibung der Zeichnungen

Anhand der Zeichnungen wird die Erfindung nachstehend eingehender beschrieben.

Es zeigen:
- Fig. 1:: Exemplarischer Aufbau eines Wärmetauschers mit berippten Heizkanälen und drei Reihen thermoelektrischer Generatoren (TEG) in Strömungsrichtung,
- Fig. 2:: einen innenberippten Kanal für ein Heizmedium mit steigender Rippendichte,
- Fig. 3:: eine Draufsicht auf einen Längsschnitt durch einen innenberippten Kanal für ein Heizmedium in zwei verschiedenen Ausführungsvarianten: a) ebene Rippen mit steigender Rippendichte b) ebene Rippen in Reihe 1 und 2 + gewellte Rippen in Reihe 3, und
- Fig. 4a:: Qualitativer Temperaturverlauf in Strömungsrichtung in einem TEG-Wärmetauscher bei durchgehender Berippung und Begrenzung durch Tmax,
- Fig. 4b:: Qualitativer Temperaturverlauf in Strömungsrichtung in einem TEG-Wärmetauscher bei steigender Rippendichte bei drei TEG-Elementen.

### Ausführungsvarianten

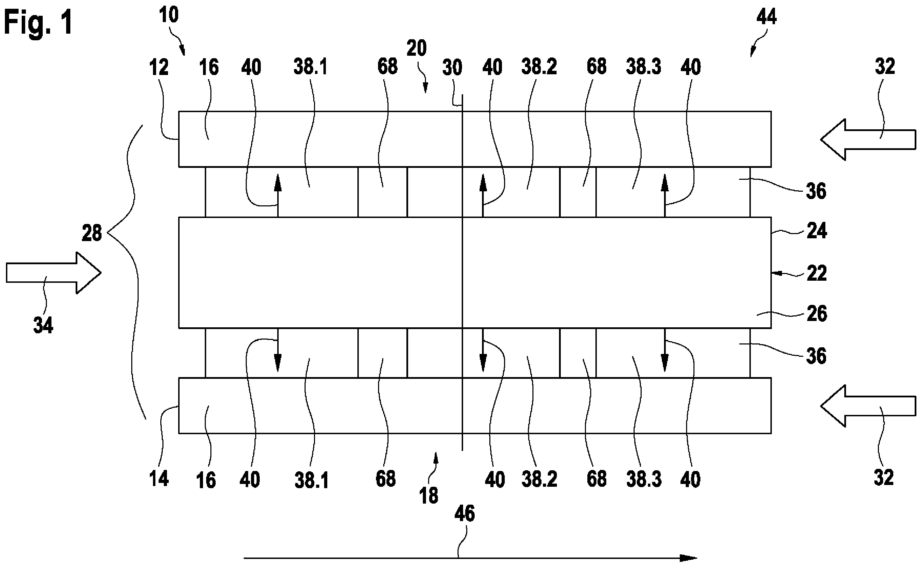

Fig. 1 stellt einen möglichen Aufbau eines Wärmetauschers mit berippten Heizkanälen und drei Reihen thermoelektrischer Generatoren (TEG) in Strömungsrichtung dar.

In einer möglichen Ausführungsart kann ein Wärmetauscher 10 als Wärmesenke zwei Kanäle 12, 14 für ein Kühlmedium 16 aufweisen. Dabei verläuft der eine Kanal 12 für das Kühlmedium 16 auf einer Unterseite 18 des Wärmetauschers 10 und der zweite Kanal 14 für das Kühlmedium 16 auf einer Oberseite 20 des Wärmetauschers 10.

In einer Mitte 22 des Wärmetauschers 10 befindet sich ein zusätzlicher Kanal 24 für ein Heizmedium 26, das als Wärmequelle fungiert.

Die Kanäle 12, 14 für das Kühlmedium 16 und der Kanal 24 für ein Heizmedium 26 erstrecken sich in zueinander parallelen Ebenen und bilden dabei einen Stapel 28 mit einer Stapelachse 30 . Entlang der Stapelachse 30 gesehen sind die Kanäle 12, 14 für das Kühlmedium 16 und der Kanal 24 für das Heizmedium 26 abwechselnd angeordnet.

Andere Kombinationen von alternierenden Kanälen 12, 14 für das Kühlmedium 16 und Kanälen 24 für das Heizmedium 26 sind ebenfalls möglich.

Durch den Kanal 24 für das Heizmedium 26 kann ein wärmeabgebendes Fluid geleitet werden, wobei das wärmeabgebende Fluid vorzugsweise aus einem Abwärmesystem stammt und besonders bevorzugt das Abgas eines Verbrennungsmotors eines Kraftfahrzeugs ist.

Durch die Kanäle 12 und 14 für das Kühlmedium 16 kann ein wärmeaufnehmendes Fluid fließen.

Vorzugsweise ist die Kühlströmungsrichtung 32 der Heizströmungsrichtung 34 entgegen gesetzt.

Innerhalb des Wärmetauschers 10, zwischen dem Kanal 12 für das Kühlmedium 16 und dem Kanal 24 für das Heizmedium 26 beziehungsweise zwischen dem Kanal 24 für das Heizmedium 26 und dem Kanal 14 für das Kühlmedium 16 befindet sich eine Anzahl von thermoelektrischen Generatoren 36.

Während des Betriebs des Wärmetauschers 10 wird der Kanal 24 des Heizmediums 26 mit einem heißen Fluid durchströmt. Die in dem Fluid enthaltene Wärme strömt als Wärmestrom 40 durch die thermoelektrischen Generatoren 36 und wird von diesen aufgenommen.

Die Kanäle 12 und 14 des Kühlmediums 16 sind mit einem Kühlfluid durchströmt, welches den Wärmestrom 40 aufnimmt, nachdem er durch die thermoelektrischen Generatoren 36 geleitet wurde.
Durch eine unterschiedliche Temperatur T1 des Heizmedium 26 und einer Temperatur T0 des Kühlmedium 16 entsteht ein Temperaturgradient ΔT. Getrieben durch die Temperaturdifferenz ΔT wandern Ladungsträger in diesen Halbleitermaterialien und es fließt ein elektrischer Strom.

Mit Hilfe der thermoelektrischen Generatoren 36 kann eine elektrische Spannung erzeugt werden, die an elektrischen Anschlüssen (nicht dargestellt) des Wärmetauschers 10 abgreifbar ist. Um ausreichend hohe Spannungen zu erhalten und damit die elektrische Leistung des Wärmetauschers 10 zu erhöhen, sind bevorzugt mehrere thermoelektrischen Generatoren 36 in dem Wärmetauscher 10 zwischen dem Kühlmedium 16 und dem Heizmedium 26 auf Deckplatten montiert und parallel und/oder in Reihe geschaltet. Diese derart angeordneten thermoelektrischen Generatoren 36, fortan als TEG-Reihen 38.1, 38.2, 38.3 bezeichnet, sind in Heizstromungsrichtung 34 angebracht.

Zwischen den Kanäle 12, 14 für das Kühlmedium 16 und dem Kanal 24 für das Heizmedium 26 befindet sich jeweils mindestens ein luftgefüllter Zwischenraum 68, der einen flexiblen Ausgleich zwischen den einzelnen Auflagepunkten der TEG-Reihen (38) ermöglicht.

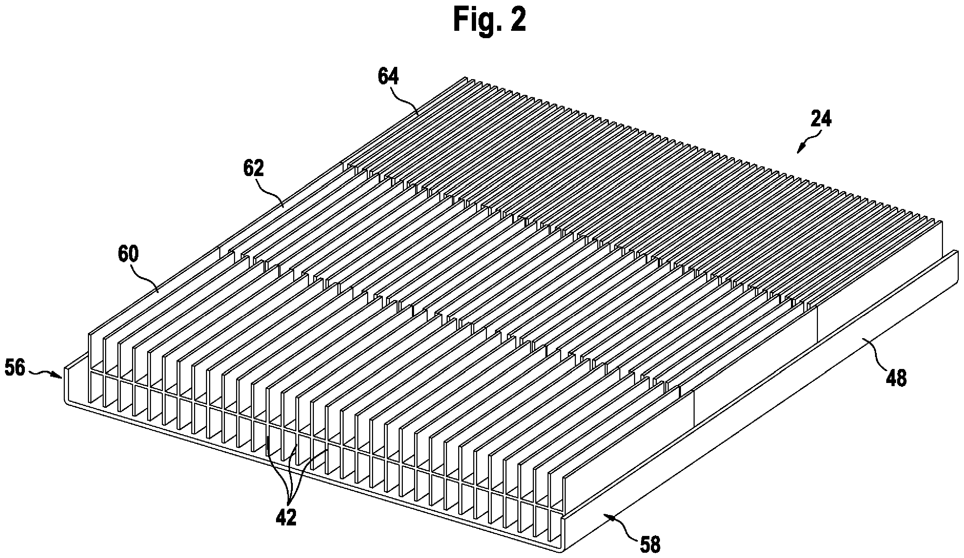

Fig. 2 zeigt einen Schnitt eines innenberippten Kanals für ein Heizmedium mit steigender Rippendichte.

Der Kanal 24 für das Heizmedium 26, umschlossen von einem Kanalmantel 48, umfasst im Innenbereich 54 eine Mehrzahl von Versteifungseinrichtungen, die in Form von Rippen 42 ausgebildet sind. Die Rippen 42 erstrecken sich bevorzugt von einer Seite 56 des Kanals 24 für das Heizmedium 26 bis zur gegenüberliegenden Seite 58 des Kanals 24 für das Heizmedium 26, um die Oberfläche der Rippen 42 zu maximieren, was zu einem verbesserten Wärmeübergang beiträgt.

Diese Rippen 42 können durch durchgängig, oder zur Verringerung der Steifigkeit, unterbrochen ausgebildet sein.

Bevorzugt ist mindestens eine Rippe 42 mit dem Kanal 24 für das Heizmedium 26 stoff-, form - oder kraftschlüssig verbunden. Neben einer sicheren und langlebigen Befestigung ist hierdurch ein besonders guter Wärmeübergang zwischen dem Kanal 24 für das Heizmedium 26 und der mindestens einen Rippe 42 gewährleistet.

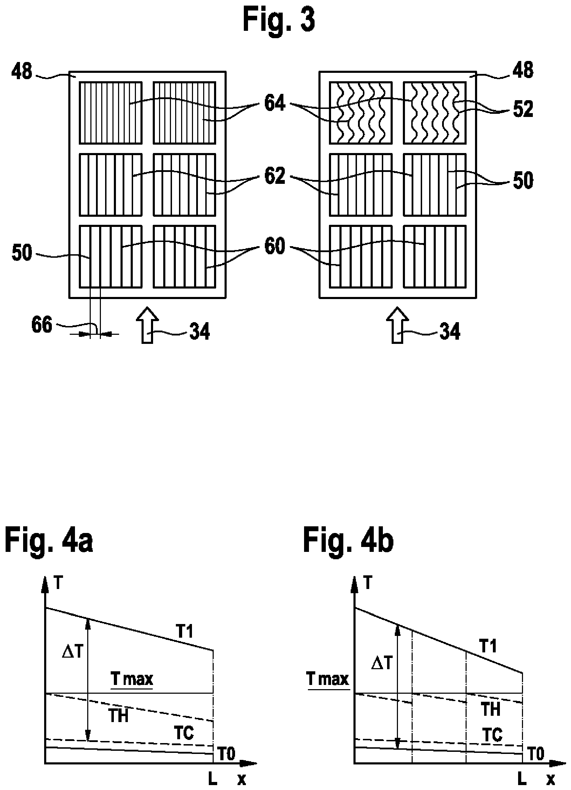

Fig. 3 zeigt eine Draufsicht auf einen Längsschnitt durch einen innenberippten Kanal für ein Heizmedium in zwei verschiedenen Ausführungsvarianten, mit ebene Rippen mit steigender Rippendichte (3a) und ebene Rippen mit steigender Rippendichte in Kombination mit gewellten Rippen.

Die als Rippen 42 ausgebildeten Versteifungselemente im Innenbereich 54 des Kanals 24 für das Heizmedium 26 können sowohl als gewellte Rippen 50, beispielsweise Herringbone-Rippen, oder als ebene Rippen 52 ausgebildet sein. Es können beliebig viele Teilungen eingeführt werden, wobei jedoch die Neigung zu Fouling-Ablagerungen, sprich durch Inhaltsstoffe des benutzten Heizmediums 26 verursachten Verschmutzung, an den Vorderkanten der Rippen 42 beachtet werden muss.

Ein Abstand 60 zwischen zwei Rippen 42 nimmt in Heizströmungsrichtung 34 entlang einer Wärmetauscherlänge 46 ab. In Fig. 2 und 3 ist das Innenbereich 54 des Kanals 24 für das Heizmedium 26 mit zunehmender Rippendichte in Heizströmungsrichtung 34, in 3 Stufen - niedrige Rippendichte 60, mittlere Rippendichte 62 und hohe Rippendichte 64 - dargestellt.

Durch diese Zunahme der Rippen 42 wird eine vergrößerte Oberfläche pro Volumen zum Austausch von Wärme des Heizmediums 26 mit dem Kühlmedium 16 bereitgestellt. Dadurch wird gewährleistet, daß der Temperaturgradient ΔT auch bei der TEG-Reihen 38.3 an einem hinteren Ende 44 des Wärmetauschers 10 ausreichend groß ist und eine effiziente Nutzung des Wärmestroms 40 ermöglicht.

Außerdem ist durch die Änderung der Anzahl der Rippen 42 sichergestellt, daß der Wirkungsgrad der einzelnen TEG-Reihen 38.1, 38.2, 38.3, trotz Abnahme der Temperatur T1 des Heizmediums 26, annährend konstant ist. Dadurch wird in den unterschiedlichen TEG-Reihen 38.1, 38.2, 38.3 eine nahezu gleichförmige elektrische Leistung erzeugt, was die Anforderungen an den Gleichstromsteller reduziert.

Eine sinnvolle Unterteilung der Rippendichte kann beispielsweise durch eine TEG-elementenweise Aufteilung vorgenommen werden. Daher, die Anzahl der Rippen 42 entlang der Wärmetauscherlänge 46 nimmt mit jeder TEG-Reihe 38.1, 38.2, 38.3 zu. Des weiteren können auch ebene Rippen 52 und gewellte Rippen 50, wie in Figur 3 (b) dargestellt, im Wärmetauscher 10 zum Zwecke der Vergleichmäßigung des Wärmestroms und der Gewichtsreduzierung kombiniert werden. Gewellte Rippen 52 weisen bei gleichem Wärmeübergang eine geringere Rippendichte und damit ein reduziertes Gewicht, jedoch auch eine geringere Festigkeit auf. Sie bieten somit Vorteile in Bereichen des Wärmetauschers, in denen ein hoher Wärmeübergang erforderlich ist. In Bereichen mit niedrigem Wärmeübergang können unter Umständen dichter gepackte ebene Rippen 52 bevorzugt werden, wenn eine externe Vorspannkraft auf das System aufgebracht wird.

Zusätzlich ermöglicht eine an den Wärmestrom 40 angepasste Anzahl der Rippen 42 bei gleicher Wärmetauscherleistung eine Material- und damit auch Gewichtsreduzierung, was zu einem Kostenersparnis während der Fertigung des Wärmetauschers 10 als auch bei seinem Betrieb führt.

Fig. 4a und 4b zeigen einen Vergleich des qualitativen Temperaturverlaufes in einem TEG-Wärmeübertrager mit durchgehender Berippung (4a) beziehungsweise in einem, wie in Fig. 3a gezeigten, TEG-Wärmetauscher bei elementweiser Zunahme der Rippendichte in Strömungsrichtung bei drei TEG-Elementen (4b).

Fig. 4a zeigt den gleichförmigen Abfall der Heißseitentemperatur TH in einem thermoelektrischen Generatoren in Abhängigkeit von der zurückgelegten Distanz x des Wärmestroms 40 in einem Wärmeübertrager mit durchgehender Berippung. Des weiteren ist eine zulässige Maximaltemperatur Tmax eingezeichnet, die die Heißseitentemperatur TH am Eintritt begrenzt. Die Temperaturdifferenz TH-TC sinkt, und damit der Wirkungsgrad des durchgängig berippten Wärmeübertragers.

Fig. 4b zeigt den stufenförmigen Abfall der Heißseitentemperatur TH in einem thermoelektrischen Generatoren in Abhängigkeit von der zurückgelegten Distanz x des Wärmestroms 40 in einem Wärmetauscher 10 mit elementweiser Zunahme der Berippung. TH ist ebenfalls durch die zulässige Maximaltemperatur Tmax beschränkt.
Die Anzahl der Rippen 42 wird nach den einzelnen TEG-Reihen 38.1, 38.2, 38.3 erhöht, um die Oberfläche für die den Wärmeübergang zu erhöhen und die TEG-Heißseitentemperatur TH anzuheben, was zu einer vergrößerten Temperaturdifferenz TH-TC führt. Während bei durchgehender Berippung ein verschlechterter Wärmeübergang auf der gesamten Wärmetauscherlänge 46 festgestellt werden muß, kann bei angepassten Rippen 42 eine Steigerung des Wärmeübergangs am hinteren Ende 44 des Wärmetauschers 10 erfolgen und die gesamte Wärmeleistung, und somit die elektrische Leistung der thermoelektrischen Generatoren, gesteigert werden.

## Patentansprüche

1. Wärmetauscher (10) für thermoelektrische Generatoren, wobei der Wärmetauscher (10) mit mindestens zwei Kanälen (12, 14) für ein Kühlmedium (16) und mindestens einem Kanal (24) für ein Heizmedium (26) ausgestattet ist, wobei der mindestens eine Kanal (24) für das Heizmedium (26) im Innenbereich (54) mit Rippen (42) bestückt ist, wobei zwischen dem Kanal (12) für das Kühlmedium und
dem Kanal (24) für das Heizmedium eine Anzahl von thermoelektrischen Generatoren (36) angeordnet ist, **dadurch gekennzeichnet dass** die Anzahl der Rippen (42) in eine Heizströmungsrichtung (34) zunimmt und dass eine Zunahme der Anzahl der Rippen (42) mit elementenweiser Zunahme der thermoelektrischen Generatoren (36) erfolgt.

2. Wärmetauscher (10) für thermoelektrische Generatoren nach einem oder mehreren der vorhergehenden Ansprüche, **dadurch gekennzeichnet, dass** die Kanäle (12, 14) für das Kühlmedium (16) und der Kanal (24) für das Heizmedium (26) sich in zueinander parallelen Ebenen erstrecken, dabei einen Stapel (28) mit einer Stapelachse (30) bilden und die Kanäle (12, 14) für das Kühlmedium (16) und der Kanal (24) für das Heizmedium (26) entlang der Stapelachse (30) abwechselnd angeordnet sind.

3. Wärmetauscher (10) für thermoelektrische Generatoren nach einem oder mehreren der vorhergehenden Ansprüche, **dadurch gekennzeichnet, dass** dem Wärmetauscher (10) ein Heizmedium (26) zugeführt wird, welches vorzugsweise aus einem Abwärmesystem stammt und besonders bevorzugt das Abgas eines Verbrennungsmotors eines Kraftfahrzeugs ist.

4. Wärmetauscher (10) für thermoelektrische Generatoren nach einem oder mehreren der vorhergehenden Ansprüche, **dadurch gekennzeichnet, dass** eine Kühlströmungsrichtung (32) einer Heizströmungsrichtung (34) entgegen gesetzt ist.

5. Wärmetauscher (10) für thermoelektrische Generatoren nach einem oder mehreren der vorhergehenden Ansprüche, **dadurch gekennzeichnet, dass** sich innerhalb des Wärmetauschers (10) mindestens eine TEG-Reihe (38) befindet, wobei die thermoelektrischen Generatoren in Heizströmungsrichtung (34) angebracht sind

6. Wärmetauscher (10) für thermoelektrische Generatoren nach einem oder mehreren der vorhergehenden Ansprüche, **dadurch gekennzeichnet, dass** die thermoelektrische Generatoren aus Halbleitermaterialien gefertigt sind.

7. Wärmetauscher (10) für thermoelektrische Generatoren nach einem oder mehreren der vorhergehenden Ansprüche, **dadurch gekennzeichnet, dass** mehrere thermoelektrische Generatoren in dem Wärmetauscher (10) zwischen dem Kühlmedium (16) und dem Heizmedium (26) parallel montiert sind.

8. Wärmetauscher (10) für thermoelektrische Generatoren nach einem oder mehreren der vorhergehenden Ansprüche, **dadurch gekennzeichnet, dass** mehrere thermoelektrische Generatoren in dem Wärmetauscher (10) zwischen dem Kühlmedium (16) und dem Heizmedium (26) in Reihe montiert sind.

9. Wärmetauscher (10) für thermoelektrische Generatoren nach einem oder mehreren der vorhergehenden Ansprüche, **dadurch gekennzeichnet, dass** mehrere thermoelektrische Generatoren in dem Wärmetauscher (10) zwischen dem Kühlmedium (16) und dem Heizmedium (26) parallel und in Reihe montiert sind.

10. Wärmetauscher (10) für thermoelektrische Generatoren nach einem oder mehreren der vorhergehenden Ansprüche, **dadurch gekennzeichnet, dass** die Rippen (42) als gewellte Rippen (50) ausgebildet sind.

11. Wärmetauscher (10) für thermoelektrische Generatoren nach einem oder mehreren der vorhergehenden Ansprüche, **dadurch gekennzeichnet, dass** die Rippen (42) als ebene Rippen (52) ausgebindet sind.

12. Wärmetauscher (10) für thermoelektrische Generatoren nach einem oder mehreren der vorhergehenden Ansprüche, **dadurch gekennzeichnet, dass** die Rippen (42) im Inneren des Kanals (24) für ein Heizmedium (26) von einer Seite (56) des Kanals (24) für ein Heizmedium (26) bis zu einer gegenüberliegenden Seite (58) Kanals (24) für ein Heizmedium (26) reichen.

13. Wärmetauscher (10) für thermoelektrische Generatoren (36) nach einem oder mehreren der vorhergehenden Ansprüche, **dadurch gekennzeichnet, dass** mindestens eine Rippe (42) mit dem Kanals (24) für ein Heizmedium (26) stoff-, form - oder kraftschlüssig verbunden ist.

## Claims

1. Heat exchanger (10) for thermoelectric generators, wherein the heat exchanger (10) is equipped with at least two ducts (12, 14) for a cooling medium (16) and at least one duct (24) for a heating medium (26), wherein the at least one duct (24) for the heating medium (26) is equipped, in the interior region (54), with fins (42), wherein a number of thermoelectric generators (36) is arranged between the duct (12) for the cooling medium and the duct (24) for the heating medium, **characterized in that** the number of fins (42) increases in a heating flow direction (34), and **in that** an increase in the number of fins (42) is realized by way of an increase in the number of elements of the thermoelectric generators (36).

2. Heat exchanger (10) for thermoelectric generators according to one or more of the preceding claims, **characterized in that** the ducts (12, 14) for the cooling medium (16) and the duct (24) for the heating medium (26) extend in mutually parallel planes, in so doing form a stack (28) with a stack axis (30), and the ducts (12, 14) for the cooling medium (16) and the duct (24) for the heating medium (26) are arranged in alternating fashion along the stack axis (30).

3. Heat exchanger (10) for thermoelectric generators according to one or more of the preceding claims, **characterized in that** a heating medium (26) which originates preferably from a waste-heat system and which is particularly preferably the exhaust gas of an internal combustion engine of a motor vehicle is supplied to the heat exchanger (10).

4. Heat exchanger (10) for thermoelectric generators according to one or more of the preceding claims, **characterized in that** a cooling flow direction (32) is opposite to a heating flow direction (34).

5. Heat exchanger (10) for thermoelectric generators according to one or more of the preceding claims, **characterized in that** at least one TEG row (38) is situated within the heat exchanger (10), wherein the thermoelectric generators are attached in the heating flow direction (34).

6. Heat exchanger (10) for thermoelectric generators according to one or more of the preceding claims, **characterized in that** the thermoelectric generators are manufactured from semiconductor materials.

7. Heat exchanger (10) for thermoelectric generators according to one or more of the preceding claims, **characterized in that** multiple thermoelectric generators are mounted in parallel in the heat exchanger (10) between the cooling medium (16) and the heating medium (26).

8. Heat exchanger (10) for thermoelectric generators according to one or more of the preceding claims, **characterized in that** multiple thermoelectric generators are mounted in series in the heat exchanger (10) between the cooling medium (16) and the heating medium (26).

9. Heat exchanger (10) for thermoelectric generators according to one or more of the preceding claims, **characterized in that** multiple thermoelectric generators are mounted in parallel and in series in the heat exchanger (10) between the cooling medium (16) and the heating medium (26).

10. Heat exchanger (10) for thermoelectric generators according to one or more of the preceding claims, **characterized in that** the fins (42) are in the form of corrugated fins (50).

11. Heat exchanger (10) for thermoelectric generators according to one or more of the preceding claims, **characterized in that** the fins (42) are in the form of planar fins (52).

12. Heat exchanger (10) for thermoelectric generators according to one or more of the preceding claims, **characterized in that** the fins (42) in the interior of the duct (24) for a heating medium (26) extend from one side (56) of the duct (24) for a heating medium (26) to an opposite side (58) of the duct (24) for a heating medium (26).

13. Heat exchanger (10) for thermoelectric generators (36) according to one or more of the preceding claims, **characterized in that** at least one fin (42) is connected in cohesive, positively locking or non-positively locking fashion to the duct (24) for a heating medium (26).

## Revendications

1. Échangeur de chaleur (10) pour générateurs thermoélectriques, l'échangeur de chaleur (10) étant muni d'au moins deux canaux (12, 14) pour un fluide de refroidissement (16) et d'au moins un canal (24) pour un fluide de chauffage (26), l'au moins un canal (24) pour le fluide de chauffage (26) étant muni de nervures (42) dans la région intérieure (54), une pluralité de générateurs thermoélectriques (36) étant disposée entre le canal (12) pour le fluide de refroidissement et le canal (24) pour le fluide de chauffage, **caractérisé en ce que** le nombre des nervures (42) augmente dans la direction d'écoulement de chauffage (34) et **en ce qu'**une augmentation du nombre des nervures (42) s'effectue avec une augmentation élémentaire des générateurs thermoélectriques (36).

2. Échangeur de chaleur (10) pour générateurs thermoélectriques selon l'une quelconque ou plusieurs des revendications précédentes, **caractérisé en ce que** les canaux (12, 14) pour le fluide de refroidissement (16) et le canal (24) pour le fluide de chauffage (26) s'étendent dans des plans parallèles, forment en l'occurrence une pile (28) avec un axe d'empilement (30) et les canaux (12, 14) pour le fluide de refroidissement (16) et le canal (24) pour le fluide de chauffage (26) sont disposés en alternance le long de l'axe d'empilement (30).

3. Échangeur de chaleur (10) pour générateurs thermoélectriques selon l'une quelconque ou plusieurs des revendications précédentes, **caractérisé en ce qu'**un fluide de chauffage (26) est acheminé à l'échangeur de chaleur (10), lequel provient de préférence d'un système à chaleur perdue et est particulièrement préférablement le gaz d'échappement d'un moteur à combustion interne d'un véhicule automobile.

4. Échangeur de chaleur (10) pour générateurs thermoélectriques selon l'une quelconque ou plusieurs des revendications précédentes, **caractérisé en ce qu'**une direction d'écoulement de refroidissement (32) est opposée à une direction d'écoulement de chauffage (34).

5. Échangeur de chaleur (10) pour générateurs thermoélectriques selon l'une quelconque ou plusieurs des revendications précédentes, **caractérisé en ce qu'**au moins une rangée de IAT (38) se trouve à l'intérieur de l'échangeur de chaleur (10), les générateurs thermoélectriques étant montés dans la direction de l'écoulement de chauffage (34).

6. Échangeur de chaleur (10) pour générateurs thermoélectriques selon l'une quelconque ou plusieurs des revendications précédentes, **caractérisé en ce que** les générateurs thermoélectriques sont fabriqués à partir de matériaux semi-conducteurs.

7. Échangeur de chaleur (10) pour générateurs thermoélectriques selon l'une quelconque ou plusieurs des revendications précédentes, **caractérisé en ce que** plusieurs générateurs thermoélectriques sont montés en parallèle dans l'échangeur de chaleur (10) entre le fluide de refroidissement (16) et le fluide de chauffage (26).

8. Échangeur de chaleur (10) pour générateurs thermoélectriques selon l'une quelconque ou plusieurs des revendications précédentes, **caractérisé en ce que** plusieurs générateurs thermoélectriques sont montés en série dans l'échangeur de chaleur (10) entre le fluide de refroidissement (16) et le fluide de chauffage (26).

9. Échangeur de chaleur (10) pour générateurs thermoélectriques selon l'une quelconque ou plusieurs des revendications précédentes, **caractérisé en ce que** plusieurs générateurs thermoélectriques sont montés en parallèle et en série dans l'échangeur de chaleur (10) entre le fluide de refroidissement (16) et le fluide de chauffage (26).

10. Échangeur de chaleur (10) pour générateurs thermoélectriques selon l'une quelconque ou plusieurs des revendications précédentes, **caractérisé en ce que** les nervures (42) sont réalisées sous forme de nervures ondulées (50).

11. Échangeur de chaleur (10) pour générateurs thermoélectriques selon l'une quelconque ou plusieurs des revendications précédentes, **caractérisé en ce que** les nervures (42) sont réalisées sous forme de nervures planes (52).

12. Échangeur de chaleur (10) pour générateurs thermoélectriques selon l'une quelconque ou plusieurs des revendications précédentes, **caractérisé en ce que** les nervures (42) à l'intérieur du canal (24) pour un fluide de chauffage (26) s'étendent depuis un côté (56) du canal (24) pour un fluide de chauffage (26) jusqu'à un côté opposé (58) du canal (24) pour un fluide de chauffage (26).

13. Échangeur de chaleur (10) pour générateurs thermoélectriques (36) selon l'une quelconque ou plusieurs des revendications précédentes, **caractérisé en ce qu'**au moins une nervure (42) est connectée au canal (24) pour un fluide de chauffage (26) par engagement par liaison de matière, par engagement par correspondance de formes ou par engagement par force.
